Europäisches Patentamt

European Patent Office

Office européen des brevets

(11) Veröffentlichungsnummer: **0 039 827**
**B1**

# (12) EUROPÄISCHE PATENTSCHRIFT

(45) Veröffentlichungstag der Patentschrift:
04.12.85

(21) Anmeldenummer: 81103208.5

(22) Anmeldetag: 29.04.81

(51) Int. Cl.⁴: **C 08 F 32/08**, C 08 F 26/06,
C 08 F 4/00, H 01 L 29/28

(54) Verfahren zur Herstellung von elektrisch leitfähigen Polymeren und deren Verwendung in der Elektrotechnik und zur antistatischen Ausrüstung von Kunststoffen.

(30) Priorität: 14.05.80 DE 3018389

(43) Veröffentlichungstag der Anmeldung:
18.11.81 Patentblatt 81/46

(45) Bekanntmachung des Hinweises auf die Patenterteilung:
04.12.85 Patentblatt 85/49

(84) Benannte Vertragsstaaten:
AT BE DE FR GB NL

(56) Entgegenhaltungen:
GB - A - 1 149 526
GB - A - 1 436 201
US - A - 3 781 259

ENCYCLOPEDIA OF POLYMER SCIENCE AND
TECHNOLOGY, John Wiley & Sons Inc., Interscience
Publisher: 1965 Band 3, Seiten 35, 39
JOURNAL OF POLYMER SCIENCE, Band 11, Seiten
639-643, 1973 John Wiley & Sons New York, U.S.A. M.
BISWAS et al.: "Some aspects of the polymerization of
alpha-methyl styrene and N-vinyl pyrrolidone by AsC13
and POCl3"
CHEMICAL ABSTRACTS, Band 68, Nr. 10, 4. März 1968,
Seite 4894, Spalte 2, Zusammenfassung 50357w
Columbus, Ohio, U.S.A.
CHEMICAL ABSTRACTS, Band 83, Nr. 22, 1. Dezember

(73) Patentinhaber: BASF Aktiengesellschaft,
Carl-Bosch-Strasse 38, D-6700 Ludwigshafen (DE)

(72) Erfinder: Muench, Volker, Dr., Luitpoldstrasse 114,
D-6700 Ludwigshafen (DE)
Erfinder: Naarmann, Herbert, Dr., Haardtblick 15,
D-6719 Wattenhelm (DE)
Erfinder: Penzien, Klaus, Dr., Benshelmer Ring 18,
D-6710 Frankenthal (DE)

(56) Entgegenhaltungen: (Fortsetzung)
1975, Seite 5, Spalte 1, Zusammenfassung 179686s
Columbus, Ohio, U.S.A. H.J. PROSSER et al.: "Cationic
polymerization of indene and acenaphthylene"
CHEMICAL ABSTRACTS, Band 72, Nr. 2, 12. januar 1970,
Seite 2, Spalte 2, Zusammenfassung 3802k Columbus,
Ohio, U.S.A. P. GIUSTI et al.: "Kinetics and mechanism
of the cationic polymerization of styrene, acenaphtylene
and some epoxides"

## Beschreibung

Die Erfindung betrifft ein Verfahren zur Herstellung von elektrisch leitfähigen Polymeren durch Polymerisation von Acenaphthylen, N-Vinylheterocyclen, 2- oder 4-Vinylpyridin oder von N,N-Divinylanilin bei Temperaturen von —80 bis +100° C in Gegenwart eines kationisch wirkenden Initiator.

Bei derartigen Polymerisationsverfahren sind kationische Katalysatoren in Mengen von 0,001 bis 10 Gew.-%, bezogen auf das Gewicht der Monomeren, erforderlich, um eine Polymerisation in Gang zu bringen.

Es ist bereits bekannt, Vinylverbindungen mit Hilfe kationisch wirkender Initiatoren zu polymerisieren (vgl. W.R. Soerenson und T.W. Camphell, »Preparative Methods of Polymer Chemistry«, Interscience Publ., New York 1968, Seite 265).

Außerdem war es aus der GB-PS 1 149 526 bekannt, daß man Acenaphthylen mit Initiatoren auf der Basis von Antimonpentafluorid polymerisieren kann.

Es ist auch bereits bekannt, elektrisch leitfähige Polymere durch oxidative Kupplung von aromatischen Verbindungen mit Hilfe von Lewis-Säuren herzustellen (vgl. »Naturwissenschaften, 56, [1969], Seite 308). Dieses Verfahren wurde jedoch nur bei aromatischen und cycloaliphatischen Systemen durchgeführt. Die erhaltenen Polymeren waren relativ niedermolekular mit Polymerisationsgraden bis zu ca. 50 und dementsprechend spröde und schwer zu verarbeiten.

Der Erfindung liegt die Aufgabe zugrunde, hochmolekulare nicht spröde Polymere mit guter Verarbeitbarkeit und hoher elektrischer Leitfähigkeit zu schaffen.

Diese Aufgabe wurde gelöst durch Polymerisation von Acenaphthylen, N-Vinylheterocyclen, 2- oder 4-Vinylpyridin oder von N,N-Divinylanilin bei Temperaturen von —80 bis +100° C, wobei als Initiator gasförmiges $SbCl_5$, $SbF_5$ oder $AsF_5$ auf dünne Filme der zu polymerisierenden Monomeren, aufgebracht auf Glas oder polymeren Trägern, vorzugsweise Kunststofffolien, einwirkt. Diese Lewis-Säuren werden in Mengen von 1 bis 50, bevorzugt 10 bis 40 Gew.-%, bezogen auf das Gewicht des jeweils eingesetzten Monomeren, verwendet.

Von den N-Vinylheterocyclen eignen sich z. B. N-Vinylcarbazol.

Als Polymerisationstemperatur wird der Bereich von —80 bis +100° C, vorzugsweise von —30 bis +100° C eingestellt. Das erfindungsgemäße Polymerisationsverfahren kann in üblichen Lösungsmitteln oder Hilfsflüssigkeiten, jedoch auch direkt in Substanz durchgeführt werden.

Die besonders bevorzugte Verfahrensvariante ist die Polymerisation, bei der dünne Filme der oben genannten Monomeren auf Glas oder polymeren Trägern, vorzugsweise Kunststofffolien — ein- oder beidseitig — mit gasförmigen Initiatoren wie $SbCl_5$, $SbF_5$ oder $AsF_5$ polymerisiert werden.

Die nach dem erfindungsgemäßen Verfahren hergestellten Polymeren sind löslich und haben Intrinsic Viskositäten $[\eta] > 0,5$, d. h. Molgewichte größer als 25000 (entsprechend der Umrechnungsformel der in Literatur »Macromolecular Synthesis«, Vol. I, [1974], Seite 83, Verlag John Wiley, New York). Die so hergestellten Polymeren haben elektrische Leitfähigkeitswerte von ca. $10^{-10}$ bis $10^{-3}$ S/cm, in Abhängigkeit von der Menge des im Polymeren verbliebenen Katalysators.

Durch Erhöhung der Menge des erfindungsgemäßen Initiators während oder nach der Polymerisation bis zu 50 Gew.-% gelingt es, elektrische Leitfähigkeiten bis zu $10^{+2}$ S/cm zu erreichen. Die Messung der elektrischen Leitfähigkeit erfolgt nach F. Beck, Ber. der Bunsenges. 68, (1964), Seite 559.

Die erfindungsgemäß hergestellten elektrisch leitfähigen Polymeren mit elektrischen Leitfähigkeiten größer als $10^{-2}$ S/cm sind zur antistatischen Ausrüstung von Kunststoffen, zum Herstellen von Sonnenzellen, zur Umwandlung und Fixierung von Strahlung sowie zur Herstellung elektrischer und magnetischer Schalter geeignet. Durch die Zusätze der starken Lewis-Säuren zu den Monomeren bzw. Polymeren entstehen sogenannte p-Leiter (vergleiche J. Chem. Educatier, Vol. 46, [1969] (2)), Seite 82.

Die in den folgenden Beispielen genannten Teile sind Gewichtsteile bzw. Molprozente.


Referenzbeispiele


Beispiel 1


Eine Lösung von 10 Teilen Acenaphthylen in 100 Teilen Diäthyläther wird bei —50° C hergestellt und bei dieser Temperatur mit 1 Teil Antimonpentafluorid versetzt. Nach der Zugabe wird die Lösung im Verlauf von 5 Stunden auf 25° C erwärmt und das Lösungsmittel abgezogen. Das Polymerisat ist löslich in Benzol und hat ein Molgewicht von ca. 150 000. Die elektrische Leitfähigkeit dieses Produktes beträgt $2.5 \cdot 10^{-2}$ S/cm.


Beispiele 2 bis 4


Wird wie im Beispiel 1 beschrieben gearbeitet, jedoch Menge und Art des Lösungsmittels und des Initiators variiert, so werden die folgenden Ergebnisse erhalten.

2

| Nr. | Lösungsmittel | | Temp. °C | Initiator Art | Teile | Leitfähigkeit S/cm 30° C |
|-----|---------------|--|----------|---------------|-------|--------------------------|
| 2 | Benzol | 100 Tl. | 10 | $AsF_5$ | 2 | $3,8 \cdot 10^{-1}$ |
| 3 | Toluol | 100 Tl. | $-50$ | $AsF_5$ | 3 | $8,5 \cdot 10^{-1}$ |
| 4 | Methylenchlorid | 100 Tl. | $-50$ | $SbF_5$ | 3 | $4,6 \cdot 10^{-1}$ |

Beispiele 5 bis 7

Es wird wie im Beispiel 1 beschrieben gearbeitet, jedoch das Monomere variiert, so werden die folgenden Ergebnisse erzielt.

| Nr. | Monomeres | Leitfähigkeit S/cm 30° C |
|-----|-----------|--------------------------|
| 5 | N-Vinylcarbazol | $0,6 \cdot 10^{-2}$ |
| 6 | 2-Vinylpyridin | $3,6 \cdot 10^{-2}$ |
| 7 | 4-Vinylpyridin | $0,9 \cdot 10^{-2}$ |

**Patentansprüche**

1. Verfahren zur Herstellung von elektrisch leitfähigen Polymeren durch Polymerisation von Acenaphthylen, N-Vinylheterocyclen, 2- oder 4-Vinylpyridin oder von N,N-Divinylanilin bei Temperaturen von $-80$ bis $+100°$C in Gegenwart eines kationisch wirkenden Initiators, dadurch gekennzeichnet, daß als Initiator gasförmiges $SbCl_5$, $SbF_5$ oder $AsF_5$ auf dünne Filme der zu polymerisierenden Monomeren, aufgebracht auf Glas oder polymeren Trägern, vorzugsweise Kunststoffolien, einwirkt.

2. Verwendung der nach Anspruch 1 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter.

3. Verwendung der nach Anspruch 1 hergestellten elektrisch leitfähigen Polymeren zur antistatischen Ausrüstung von Kunststoffen.

**Claims**

1. A process for the preparation of electrically conductive polymers by polymerizing acenaphthylene, N-vinylheterocyclics, 2- or 4-vinylpyridine, or N,N-divinylaniline, at from $-80$ to $+100°$C in the presence of a cationic initiator, wherein gaseous $SbCl_5$, $SbF_5$ or $AsF_5$, as initiator, acts on thin films of the monomers to be polymerized, applied to glass or to a polymeric base, preferably a plastic film.

2. The use of the electrically conductive polymers prepared as claimed in claim 1 in electrical engineering for the production of solar cells, for the conversion and fixation of radiation, and for the production of electrical and magnetic switches.

3. The use of the electrically conductive polymers prepared as claimed in claim 1 for the antistatic treatment of plastics.

3

**Revendications**

1. Procédé de préparation de polymères conducteurs de l'électricité par polymérisation d'acénaphtylène, de composés hétérocycliques N-vinyliques, de la vinyl-2 ou de la vinyl-4 pyridine ou de la N,N-divinyl-aniline à des températures comprises entre −80 et +100°C en présence d'un initiateur à effet cationique, caractérisé en ce que l'on fait agir du $SbCl_5$, du $SbF_5$ ou du $AsF_5$ gazeux sur les monomères à polymériser, déposés sous forme de minces pellicules sur du verre ou des supports polymères, de préférence des feuils en matière plastique.

2. Utilisation des polymères conducteurs de l'électricité, préparés par le procédé de la revendication 1, dans le domaine électro-technique pour la fabrication de cellules solaires, pour la transformation et la fixation de radiations et pour la fabrication de commutateurs électriques ou magnétiques.

3. Utilisation des polymères conducteurs de l'électricité, préparés par le procédé de la revendication 1, pour l'apprêtage anti-statique de matières plastiques.